# EUROPEAN PATENT APPLICATION

(11) **EP 3 070 838 A1**
(43) Date of publication of application: **21.09.2016**
(21) Application number: 15159268.0
(22) Date of filing: 16.03.2015
(51) Int. Cl.: H03D 13/00

(54) **PHASE DETECTOR AND METHOD OF OPERATING THE SAME**

(71) Applicant: Deutsches Elektronen-Synchrotron DESY, 22603 Hamburg (DE)
(72) Inventor: Schlarb, Holger, 22549 Hamburg (DE); Jablonski, Szymon, 22547 Hamburg (DE)
(74) Representative: Seemann & Partner

(57) **Abstract**

An electronic device (20) an method of operating a same, the electronic device (20) comprising a phase detection unit (1) having a first A/D-converter (31) arranged in a first channel and a second A/D-converter (32) arranged in a second channel, the phase detection unit (1) being configured to detect a relative phase drift between a first RF-signal (A1) received at the first channel and a second RF-signal (B1) received at the second channel, wherein the phase detection unit (1) is further configured to determine a phase drift value over a full 360° phase range in that the digitized first signal being output by the first A/D-converter (31) and the digitized second signal being output by the second A/D-converter (32) are compared in a digital domain, characterized in that the first A/D-converter (31) and the second A/D-converter (32) are housed in a common package (3) in that the first A/D-converter (31) and the second A/D-converter (32) experience at least approximately same environmental conditions, in particular with respect to temperature and/or humidity.

## Description

The invention relates to an electronic device comprising a phase detection unit having a first A/D-converter arranged in a first channel and a second A/D-converter arranged in a second channel, the phase detection unit being configured to detect a relative phase drift between a first RF-signal received at a first input terminal of the first channel and a second RF-signal received at a second input terminal of the second channel, wherein the phase detection unit is further configured to determine a phase drift value over a full 360° phase range being indicative of a phase drift between the first and the second RF-signal in that the digitized first signal being output by the first A/D-converter and the digitized second signal being output by the second A/D-converter are compared in a digital domain. Furthermore, the invention relates to a method of operating this electronic device.

Modern phase detectors, which are applied for example in synchronization systems of particle accelerators, have to fulfill high demands with respect to stability and accuracy. Particularly, challenging are applications in which an RF-signal phase drift has to be measured with fs-accuracy over a long period of time, for example for several hours or even days. This task becomes technically even more challenging if the detection shall be performed over a full 2π phase detection range.

Various technologies can be applied to detect the phase of an RF-signal. Common off the shelf phase detectors provide phase information as a continuous analog signal, which can be digitized by an ADC (analog-to-digital converter) for further processing of data. An alternative is an analog I/Q detector, which decomposes an RF-signal into I and Q components. However, these phase detectors lack sufficient linearity to meet high demands for precise femtosecond phase detection over the full 360° phase range. The detectors are typically implemented in systems comprising phase shift compensation units, in which the phase difference between two signals is kept constant using a feedback loop.

In another solution for phase detection, I/Q sampling and digital down-conversion is performed, where an electrical signal is digitized and the I/Q information is extracted from samples in a purely digital way. An RF signal can be firstly down-converted to an intermediate frequency or can be directly digitized omitting the down-conversion stage. These detectors are capable of measuring phase drifts over a full 2π range with the required precision and, contrary to the analog I/Q detectors, they are not susceptible to errors associated with gain matching, D/C offsets, quadrature phase errors, carrier leakage and impedance matching.

A high precision phase measurement is for example disclosed in: G. Huang, L.R. Doolittle, J.W. Staples, R. Wilcox, J.M. Byrd: "SIGNAL PROCESSING FOR HIGH PRECISION PHASE MEASUREMENTS"; Proceeding of BIW10, Santa Fee, New Mexico, US. In this system, there is a heterodyne digital receiver, wherein one source of phase error in this receiver is a thermal variation of the input stage. To compensate for this thermal drift, a CW calibration signal is sent through the same components together with the RF-signal to measure and compensate for the component drift. An FPGA based digital signal processing unit is applied to measure and reconstruct the RF-signal after application of an appropriate correction.

It is an object of the invention to provide an electronic device comprising a phase detection unit and a method of operating the same, wherein a phase drift between a first and a second signal channel shall be determined over a full 360°-range (2π-range) with high accuracy for a long period of time.

The object is solved by an electronic device comprising a phase detection unit having a first A/D-converter arranged in a first channel and a second A/D-converter arranged in a second channel, the phase detection unit being configured to detect a relative phase drift between a first RF-signal received at a first input terminal of the first channel and a second RF-signal received at a second input terminal of the second channel, wherein the phase detection unit is further configured to determine a phase drift value over a full 360° phase range being indicative of a phase drift between the first and the second RF-signal in that the digitized first signal being output by the first A/D-converter and the digitized second signal being output by the second A/D-converter are compared in a digital domain, wherein the electronic device is further enhanced in that the first A/D-converter and the second A/D-converter are housed in a common package in that the first A/D-converter and the second A/D-converter experience at least approximately same environmental conditions, in particular with respect to temperature and/or humidity.

The electronic device according to aspects of the invention is configured to measure phase drifts between a first and a second signal. For example, the phase drift is measured between a reference oscillating signal and an RF-signal distributed to a remote location. This particularly applies in a situation, when the electronic device is implemented in a synchronization system of a particle accelerator. Since a relative phase drift between two RF-signals is measured, the absolute stability of each detector channel is not crucial. However, a relative phase drift between the two channels is minimized by implementing a dual ADC, which means a first and a second A/D-converter being implemented on one and the same semiconductor substrate, for example.

It has been acknowledged that temperature and humidity variations play the most important rule with respect to deterioration of the measurement accuracy between the two channels, in particular for long term measurements. Consequently, the electronic device according to aspects of the invention includes a first and a second AD-converter, which experience at least approximately the same environmental conditions, in particular with respect to temperature and/or humidity.

In an advantageous embodiment of the invention, there is the first A/D-converter and the second A/D-converter being thermally coupled via a thermal bridge. For example, this thermal bridge is a metal part being manufactured from a thermally highly conductive material, such as copper, aluminum or the like. Bringing the first and the second A/D-converter to an at least approximately identical temperature significantly increases the stability of the differential measurement. In other words, the electronic device is capable of performing an ultra-stable phase difference measurement.

The electronic device is further enhanced in that the thermal bridge between the first A/D-converter and the second A/D-converter is implemented in that the first A/D-converter and the second A/D-converter are:
arranged in (or on) a common leadframe and/or
manufactured on a single and common semiconductor substrate.

The above-referenced implementation of the electronic device represents a very efficient solution for thermally coupling the first and the second A/D-converter.

For further stabilization of the measurement, according to another embodiment of the invention, the first A/D-converter and the second A/D-converter are embedded in a single common and uniform mold in that the first A/D-converter and the second A/D-converter experience at least approximately same humidity. In other words, the first and the second A/D-converter are packed in a common housing or mold and due to this measure the two elements experience almost identical environmental conditions, in particular with respect to humidity.

Furthermore, temperature and humidity can be actively controlled by placing the first A/D-converter and the second A/D-converter in a temperature and humidity controlled housing, according to still another embodiment of the invention. This enhances the stability of the relative phase drift measurement, in particular in long term measurements, still further.

While the technical approach forming the basis of the aforementioned embodiments mainly approaches the problem of longterm stability by passively coupling the two A/D-converters with respect to environmental conditions, the stability of the measurement can also be enhanced by actively compensating for drifts in a subsequent analysis of the captured signals.

For example, as a first measure, the electronic device is designed such that the first A/D-converter and the second A/D-converter are configured to receive a common clock signal having a common clock frequency. The results of the two parallel analog-to-digital conversions, which are performed on the first and second A/D-converter, respectively, are consequently rendered more comparable by feeding a common clock signal to both of the A/D-converters.

Furthermore, the electronic device is advantageously configured in that it further comprises a calibrating unit having a splitter being coupled to a first combiner and to a second combiner, wherein the splitter is configured to receive a calibrating signal having a calibrating frequency, to split the calibrating signal and to couple a first split calibrating signal to the first combiner and a second split calibrating signal to the second combiner, wherein the first combiner forming part of the first channel is configured to combine the calibrating signal and the first RF-signal and the second combiner forming part of the second channel is configured to combine the calibrating signal and the second RF-signal.

The calibrating signal is a signal within the meaning of a second tone. In particular, the calibrating unit is drift free with respect to errors in the analog front ends which can be detected through analysis of the difference between the second tone in the first and the second channel. The two tone RF-signals are converted to a digital domain by the dual-ADC and relative phase shifts or drift of both (originally identical) tones are detected using a non-I/Q algorithm. In other words, there is no analog I/Q-detector, which decomposes an RF-signal into I and Q components.

The electronic device is furthermore enhanced in that it is configured to calibrate the first channel and the second channel in that a phase difference between the first split calibrating signal detected in the first channel and the second split calibrating signal detected in second channel is determined and a phase difference between the first oscillating signal and the second oscillating signal is corrected by said detected phase drift between the first and second split calibrating signals in a digital domain. Active phase shift difference correction is advantageously performed for the first and the second channel.

In still another advantageous embodiment of the invention, the electronic device is configured in that the calibration unit comprises the splitter, the first combiner and the second combiner, which are housed in a temperature and humidity controlled housing. Placing these components in a temperature and humidity controlled housing significantly increases the stability of the phase detection, as could be determined in practical experiments.

For further enhancement of the accuracy of the phase drift measurement, a circuitry layout of the calibrating unit is arranged in that a first phase drift acquired by the first split calibrating signal on an electrical path from the splitter to the first combiner and a second phase drift acquired by the second split calibrating signal on an electrical path from the splitter to the second combiner is below a predetermined measurement accuracy value.

By this particular conductor path layout of, for example a circuit board, causes a delay between the splitter and the first combiner to be almost identical to a delay between the splitter and the second combiner. In other words, the influence of an electrical path length, for example the length of the wiring between the aforementioned units, on the signal propagation delay is almost identical. The splitters and the combiners themselves are taken into account when calculating this electrical path.

For a best performance, the measured signal and the calibration signal frequency should be close to one another. However, their information bandwidths should not overlap. Furthermore, it is possible to apply more than one calibration tone. Theoretically, the phase detection is most accurate when applying a plurality of calibration tones, because the measurement errors can be averaged out. On the other hand, the more calibration tones are used the lower is the power of the individual signals and the lower is the signal-to-noise ratio, which degrades the phase detection performance. To get the highest measurement accuracy the number of used calibration tones must be optimized for each individual system.

In another advantageous embodiment of the invention, there is an electronic device further comprising a down-converter stage being arranged between the calibrating unit and the phase detection unit.

Furthermore, the electronic device is advantageously configured in that relative phase drifts between the first channel and the second channel over 360°-phases are determined with accuracy in a fs-range, in particular between 10 fs and 100 fs. Further in particular, the electronic device is configured to detect over a 360° relative phase drift value with an accuracy up to 20 fs over a timespan or period of more than one day, which means for more than 24 hours.

The object is further solved by a method of operating an electronic device according to one or more of the afore-mentioned embodiments. The first A/D-converter and the second A/D-converter of the detection unit are operated under at least approximately same environmental conditions, in particular with respect to temperature and/or humidity.

Same or similar advantages, which have been mentioned with respect to the electronic device, apply to this method in a same or similar way and shall therefore not be repeated.

Furthermore, the method can be further enhanced in that the calibrating unit comprises a splitter being coupled to a first combiner and to a second combiner. The first and the second combiner as well as the splitter are operated under at least approximately similar, in particular constant temperature and/or humidity conditions.

Further characteristics of the invention will become apparent from the description of the embodiments according to the invention together with the claims and the included drawings. Embodiments according to the invention can fulfill individual characteristics or a combination of several characteristics.

The invention is described below, without restricting the general intent of the invention, based on exemplary embodiments, wherein reference is made expressly to the drawings with regard to the disclosure of all details according to the invention that are not explained in greater detail in the text. The drawings show in:
- Fig. 1: a simplified block diagram of a phase detection unit,
- Fig. 2: another simplified block diagram of a phase detection unit comprising a calibration unit and
- Fig.3: another simplified block diagram illustrating a down-converter stage in a phase detection unit.

In the drawings, the same or similar types of elements or respectively corresponding parts are provided with the same reference numbers in order to prevent the item from needing to be reintroduced.

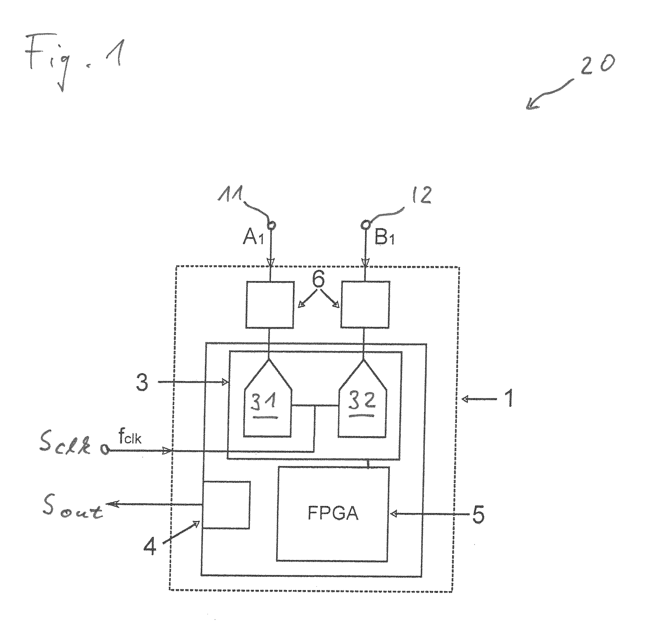

In fig. 1, there is a simplified block diagram of an electronic device 20 having a phase detection unit 1. The phase detection unit 1 comprises a first A/D-converter 31 and a second A/D-converter 32 being housed in a common package 3. The first A/D-converter 31 is arranged in a first channel of the phase detection unit 1 receiving a first RF-signal A1 at a first input terminal 11. The second A/D-converter 32 is arranged in a second channel receiving a second RF-signal B1 at a second input terminal 12. The phase detection unit 1 is configured to detect a relative phase drift between the first RF-signal A1 and the second RF-signal B1. It is further configured to determine a phase drift value over a full 360° phase range (2π-phase drift) between the two signals A1, B1 received at the first and the second input terminal 11, 12. The digitized output values of the first and the second A/D-converter 31, 32 are fed to a processing unit 5. In the given embodiment, the processing unit 5 is implemented as a field programmable gate array (FPGA). The digitized output values of the first and the second A/D-converter 31, 32 are compared in the digital domain, which means in particular in the FPGA-unit. The comparison results are made available for further data processing at an output interface 4; the output signal is referred to as Sout.

The first and the second RF-signals A1, B1, which are received at the first and the second input terminal 11,12, are fed through RF front ends 6 to the first and the second A/D-converter 31, 32, respectively.

For a precise determination of the phase drift between the first and the second RF-signal A1, B1 with fs-accuracy over a long period of time, for example over a timespan of several hours or days, the accuracy and stability of the A/D-conversion was found to be crucial. This is why the first A/D-converter 31 and the second A/D-converter 32 are housed in a common package 3 in that the first A/D-converter 31 and the second A/D-converter 32 experience at least approximately same environmental conditions. In particular, this applies to temperature and/or humidity.

In order to achieve these almost identical operating conditions for the first and second A/D-converter 31, 32, the two components are thermally coupled via a thermal bridge, according to an embodiment of the invention. For example, this thermal bridge is a suitably structured part of a thermally highly conductive material, for example copper or aluminum. According to another embodiment of the invention, the two A/D-converters 31, 32 are arranged in or on a common lead frame acing as a thermal bridge. Subsequently, they are preferably molded in a single and common mold or housing. To further enhance the stability of the phase detection, the first and the second A/D-converter 31, 32 are manufactured on a single and common semiconductor substrate. The semiconductor substrate itself will then act as a thermal bridge coupling the two A/D-converters 31, 32. Optionally, the first and the second A/D-converter 31, 32, which can be configured as a dual A/D-converter, can be further housed or encapsulated in a temperature and/or humidity controlled housing.

Furthermore, it is advantageous with respect to stability when the first and the second A/D-converter 31, 32 are configured to receive a common clock signal Sclk. Consequently, both A/D-converters 31, 32 are clocked with the common clock frequency fclk.

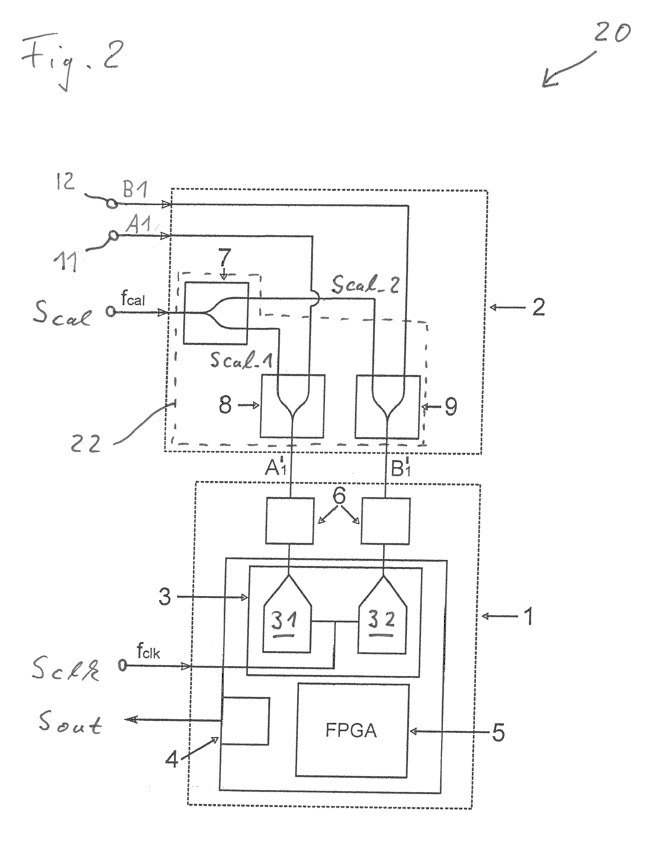

In fig. 2, there is another simplified block diagram of an electronic device 20 according to another embodiment of the invention. It comprises a phase detection unit 1, which is configured similar to the phase detection unit 1 in fig. 1. Further details are mentioned above.

However, in addition to this, there is a calibration unit 2 comprising a splitter 7 being coupled to a first combiner 8 and to a second combiner 9. The splitter 7 receives a calibrating signal Scal having a calibrating frequency fcal. The calibrating signal Scal is a signal within the meaning of a second tone. The calibrating signal Scal is split by the splitter 7 into a first split calibrating signal Scal_1 and a second split calibrating signal Scal_2. The first and the second split calibrating signals Scal_1, Scal_2 are identical signals, in particular with respect to their frequency, which is the calibrating frequency fcal. Furthermore, the calibrating unit 2 receives the first RF-signal A1 at the first input terminal 11 and the second RF-signal B1 at the second input terminal 12. In the first combiner 8 the first RF-signal A1 and the first split calibrating signal Scal_1 are combined into a first RF-signal A'1, which is coupled to the phase detection unit 1 via the RF-front end 6. Similarly, in the second combiner 9, the second RF-signal B1 is combined with the second split calibrating signal Scal_2 and consequently, at the output of the second combiner 9, there is the second RF-signal B'1. In other words, the first combiner 8 and the second combiner 9 form part of the first and the second channel of the electronic device 20, respectively.

The first and the second RF-signals A'1, B'1 are converted in the first and the second A/D-converter 31, 32 and the combined signals are processed in the processing unit 5 in the digital domain.

A drift between the first and the second channel can be digitally detected by comparing the components of the respective signals, which are due to the first and second split calibrating signals Scal_1, Scal_2. Theoretically, the first and the second split calibrating signals Scal_1, Scal_2 are identical. Detected deviations are therefore due to drifts or variations between the two signal channels in the electronic device 20. Advantageously, these can be corrected in the digital domain, which significantly enhances the detection accuracy of the phase drift between the first and the second RF-signal A1, B1.

The detection, in particular with respect to long-term stability can be further enhanced by placing the splitter 7, the first combiner 8 and the second combiner 9 in a temperature and/or humidity controlled housing 22. The units experience almost identical conditions with respect to temperature and/or humidity, which are for example constant over time.

Furthermore, the circuitry layout of the calibrating unit 2 is arranged in that a first phase drift acquired by the first split calibrating signal Scal_1 on the path between the splitter 7 and the first combiner 8 and a second phase drift, which is acquired by the second split calibrating signal Scal_2 on the path between the splitter 7 and the second combiner 9, is below a predetermined measurement accuracy value. In other words, the named conduction paths are preferably of almost identical electrical length, which is naturally not depicted in the schematic drawing of fig. 2.

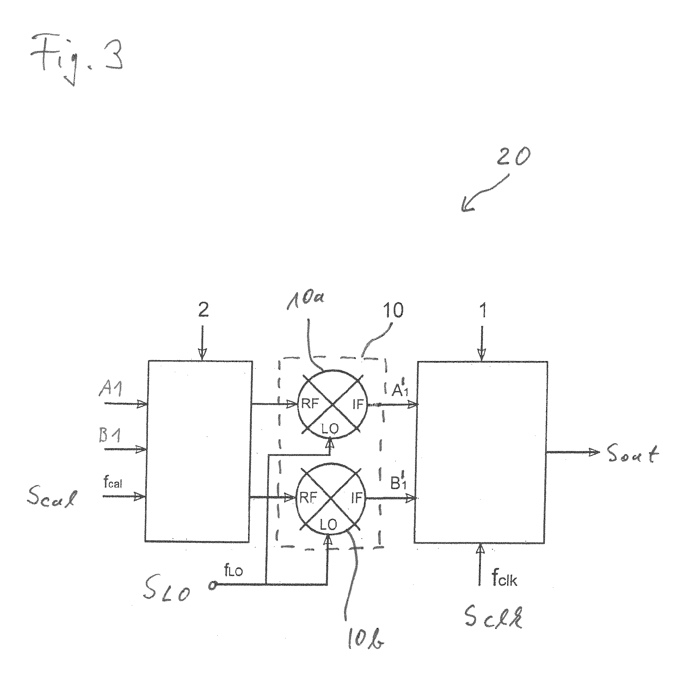

In fig. 3, there is another simplified block diagram illustrating an electronic device 20 according to another embodiment of the invention. The electronic device 20 comprises a phase detection unit 1 and a calibration unit 2, which are preferably configured according to the afore-mentioned embodiments.

In addition to this, the electronic device 20 comprises a down-converter stage 10 comprising a first mixer 10a and a second mixer 10b forming part of the first and the second channel, respectively. Advantageously, this renders the electronic device 20 suitable to detect a phase drift between RF-signals A1, B1 having frequencies above the frequencies bandwidth of the A/D-converters 31, 32 (figs. 1 and 2). This extends the allowed frequency range considerably. Furthermore, at high signal frequencies, there is a high influence of the A/D-converter aperture jitter and the clock jitter to the measurement accuracy. If noise is not acceptable in a particular application, it can be reduced by applying the down-converter stage 10 between the calibration unit 2 and the phase detection unit 1. After down-conversion the first combined RF-signal A1' and the second combined RF-signal B1' do fit in the bandwidth of the A/D-converters 31, 32. Advantageously, since the down-converter stage 10 is placed behind the calibration unit 2, additive phase drifts of the down-converter stage 10 are removed. The sampling is less effected by the aperture jitter and the clock jitter of the A/D-converters 31, 32, which improves the phase detection accuracy.

In the first and the second mixer 10a, 10b of the down-converter stage 10, the RF-signals, indicated by "RF", are mixed with a lower or higher frequency signal or heterodyne SLO having the lower or higher frequency fLO, which results in an output referred to as "IF".

Advantageously, the electronic device 20 according to embodiments of the invention is configured to detect a phase drift value over a full 360° phase range, which is the output signal Sout or part of that signal, in a fs-range. In particular, a phase drift value between 10 fs and 100 fs, in particular a 360°-phase drift value of up to 20 fs over a time span of more than a day can be determined.

The electronic device 20 fulfills high demands on stability and accuracy to meet the goals of synchronization systems. This is achieved by a circuit design, which is symmetric with respect to signal delay in both channels.

In a method of operating the electronic device 20, the important step is operating the first A/D-converter 31 and the second A/D-converter 32 of the detection unit 1 under at least approximately the same environmental conditions, in particular with respect to temperature and/or humidity. Similarly, in an advantageous embodiment of this method of operating the electronic device 20, the splitter 7 and the first and the second combiner 8, 9 are also operated under at least approximately similar, in particular constant, temperature and/or humidity conditions.

All named characteristics, including those taken from the drawings alone, and individual characteristics, which are disclosed in combination with other characteristics, are considered alone and in combination as important to the invention. Embodiments according to the invention can be fulfilled through individual characteristics or a combination of several characteristics. Features which are combined with the wording "in particular" or "especially" are to be treated as preferred embodiments.

### List of References

- 1: phase detection unit
- 2: calibration unit
- 3: common package
- 4: output interface
- 5: processing unit
- 6: RF-front end
- 7: splitter
- 8: first combiner
- 9: second combiner
- 10: down-converter stage
- 10a: first mixer
- 10b: second mixer
- 11: first input terminal
- 12: second input terminal
- 20: electronic device
- 22: housing
- 31: first A/D-converter
- 32: second A/D-converter
- A1: first RF-signal
- B1: second RF-signal
- A'1: combined first RF-signal
- B'1: combined second RF-signal
- Sout: output signal
- Sclk: clock signal
- fclk: clock frequency
- Scal_1: first split calibrating signal
- Scal_2: second split calibrating signal
- SLO: lower or higher frequency signal
- fLO: lower or higher frequency

## Claims

1. An electronic device (20) comprising a phase detection unit (1) having a first A/D-converter (31) arranged in a first channel and a second A/D-converter (32) arranged in a second channel, the phase detection unit (1) being configured to detect a relative phase drift between a first RF-signal (A1) received at a first input terminal (11) of the first channel and a second RF-signal (B1) received at a second input terminal (12) of the second channel, wherein the phase detection unit (1) is further configured to determine a phase drift value over a full 360° phase range being indicative of a phase drift between the first and the second RF-signal (A1, B1) in that the digitized first signal being output by the first A/D-converter (31) and the digitized second signal being output by the second A/D-converter (32) are compared in a digital domain, **characterized in that** the first A/D-converter (31) and the second A/D-converter (32) are housed in a common package (3) **in that** the first A/D-converter (31) and the second A/D-converter (32) experience at least approximately same environmental conditions, in particular with respect to temperature and/or humidity.

2. The electronic device (20) according to claim 1, wherein the first A/D-converter (31) and the second A/D-converter (32) are thermally coupled via a thermal bridge.

3. The electronic device (20) according to claim 2, wherein the thermal bridge between the first A/D-converter (31) and the second A/D-converter (32) is implemented in that the first A/D-converter (31) and the second A/D-converter (32) are:
arranged in a common leadframe and/or
manufactured on a single and common semiconductor substrate.

4. The electronic device (20) according to anyone of the preceding claims, wherein the first A/D-converter (31) and the second A/D-converter (32) are embedded in a single common and uniform mold in that the first A/D-converter (31) and the second A/D-converter (32) experience at least approximately same humidity.

5. The electronic device (20) according to anyone of the preceding claims, wherein the first A/D-converter (31) and the second A/D-converter (32) are housed in a temperature and humidity controlled housing.

6. The electronic device (20) according to anyone of the preceding claims, wherein the first A/D-converter (31) and the second A/D-converter (32) are configured to receive a common clock signal (Sclk) having a common clock frequency (fclk)

7. The electronic device (20) according to anyone of the preceding claims, further comprising a calibrating unit (2) having a splitter (7) being coupled to a first combiner (8) and to a second combiner (9), wherein the splitter (7) is configured to receive a calibrating signal (Scal) having a calibrating frequency (fcal), to split the calibrating signal (Scal) and to couple a first split calibrating signal (Scal_1) to the first combiner (8) and a second split calibrating signal (Scal_2) to the second combiner (9), wherein the first combiner (8) forming part of the first channel is configured to combine the calibrating signal (Scal) and the first RF-signal (A1) and the second combiner (9) forming part of the second channel is configured to combine the calibrating signal (Scal) and the second RF-signal (B1).

8. The electronic device (20) according to claim 7, being further configured to calibrate the first channel and the second channel in that a phase difference between the first split calibrating signal (Scal_1) detected in the first channel and the second split calibrating signal (Scal_2) detected in second channel is determined and a phase difference between the first RF-signal (A1) and the second RF-signal (B1) is corrected by said detected phase drift between the first and second split calibrating signals (Scal_1, Scal_2) in a digital domain.

9. The electronic device (20) according to claim 7 or 8, wherein the calibrating unit (2) comprising the splitter (7), the first combiner (8) and to the second combiner (9) is housed in a temperature and humidity controlled housing.

10. The electronic device (20) according to any of claims 7 to 9, wherein a circuitry layout of the calibrating unit (2) is arranged in that a first phase drift acquired by the first split calibrating signal (Scal_1) on an electrical path from the splitter (7) to the first combiner (8) and a second phase drift acquired by the second split calibrating signal (Scal_2) on an electrical path from the splitter (7) to the second combiner (9) is below a predetermined measurement accuracy value.

11. The electronic device (20) according to anyone of claims 7 to 10, further comprising a down-converter stage (10) being arranged between the calibrating unit (2) and the phase detection unit (1).

12. The electronic device (20) according to anyone of the preceding claims, being configured to detect an arbitrary relative phase drift value with fs accuracy, in particular between 10 fs and 100 fs, further in particular over 360°-relative phase drift value with an accuracy up to 20 fs over a timespan of more than 24 hours.

13. A method of operating an electronic device (20) according to anyone of claims 1 to 12, wherein the first A/D-converter (31) and the second A/D-converter (32) of the detection unit (1) are operated under at least approximately same environmental conditions, in particular with respect to temperature and/or humidity.

14. The method according to claim 13, wherein the calibrating unit (2) comprising a splitter (7) being coupled to a first combiner (8) and to a second combiner (9), is operated under at least approximately similar, in particular constant, temperature and/or humidity condition.
